# EUROPÄISCHE PATENTANMELDUNG

(11) **EP 2 525 422 A1**
(43) Veröffentlichungstag der Anmeldung: **21.11.2012**
(21) Anmeldenummer: 11166190.6
(22) Anmeldetag: 16.05.2011
(51) Int. Cl.: H01L 41/04, G02B 26/08, B60Q 1/076, F21V 7/16

(54) **Verfahren zum Betreiben eines Bauteils**

(71) Anmelder: Bayer Material Science AG, 51368 Leverkusen (DE)
(72) Erfinder: Jenninger, Werner, verstorben (FR); Wagner, Joachim, 51061 Köln (DE); Benecke, Carsten, 79576 Weil am Rhein (DE); Hedderich, Wilfried, 40724 Hilden (DE)

(57) **Zusammenfassung**

Die Erfindung betrifft ein Verfahren zum Betreiben eines Bauteils (4), wobei das Bauteil (4) mindestens eine elektromechanische Wandlereinrichtung umfassend mindestens eine zwischen einer ersten Elektrode (8) und mindestens einer zweiten Elektrode (10) angeordnete elektroaktive Schicht (12) aufweist. Das Verfahren umfasst Einstellen eines vorgebbaren Zustands des Bauteils (4) vor dem Betreiben des Bauteils (4), wobei mindestens ein erster Parameterwert eines den vorgebbaren Zustand bestimmenden ersten Parameters als erster Sollwert bestimmt wird, Erfassen eines Istwertes des ersten Parameters während des Betriebs des Bauteils (4), Vergleichen des erfassten Istwertes des ersten Parameters mit dem bestimmten Sollwert des ersten Parameters, und Anlegen eines elektrischen Signals an die erste Elektrode (8) und die mindestens zweite Elektrode (10) bei Detektion einer vorgebbaren Abweichung des Istwertes des ersten Parameters von dem Sollwert des ersten Parameters, derart, dass die Abweichung des Istwertes des ersten Parameters von dem Sollwert des ersten Parameters zumindest reduziert wird.

## Beschreibung

Die Erfindung betrifft ein Verfahren zum Betreiben eines Bauteils. Das zu betreibende Bauteil weist mindestens eine elektromechanische Wandlereinrichtung umfassend mindestens eine zwischen einer ersten Elektrode und mindestens einer zweiten Elektrode angeordnete elektroaktive Schicht auf. Darüber hinaus betrifft die Erfindung ein System, eine Verwendung des Systems und einen Scheinwerfer umfassend das System.

Kunststoffverbundstoffe werden in einer Vielzahl von Anwendungen eingesetzt. Beispielsweise wird ein entsprechender Schichtverbund als Verpackungsmaterial, Isolationsmaterial oder als Konstruktionsmaterial verwendet. Neben diesem herkömmlichen Einsatzzweck, werden Schichtverbunde vermehrt als aktive Komponenten in Generatoranwendungen, Sensoranwendungen oder Aktuatoranwendungen eingesetzt.

Insbesondere ist es bekannt, elektromechanische Wandlereinrichtungen als Aktuatoren einzusetzen. Eine elektromechanische Wandlereinrichtung kann mindestens eine zwischen einer ersten und mindestens einer weiteren Elektrode angeordnete elektroaktive Schicht umfassen. Wird an den Elektroden ein elektrisches Signal angelegt, wie eine Spannung, bildet sich ein elektrisches Feld zwischen den Elektroden aus. Hierbei kann die Form bzw. Ausdehnung der elektromechanischen Wandlereinrichtung durch eine entsprechende Änderung des elektrischen Signals geändert werden.

Elektromechanische Aktuatoren werden beispielsweise dazu eingesetzt, Bauteile zu positionieren. Beispielsweise offenbart die WO 01/31716 A1 ein System, bei dem eine Membran mittels einer Vielzahl an Aktuatoren aufgespannt wird. Nachteilig an dem System gemäß dem Stand der Technik ist jedoch, dass das System komplex ausgebildet und insbesondere eine Vielzahl Aktuatoren benötigt werden. Ferner wird die Membran in der Regel vor einem Betrieb der Membran in einen gewünschten Zustand gebracht. Beispielsweise werden die Aktuatoren entsprechend eingestellt.

Problematisch ist jedoch, dass sich während des Betriebs der Zustand der Membran aufgrund von Feuchtigkeits-, Druck- und/oder Temperaturschwankungen, ändern kann. Werden die ungewünschten Abweichungen von einem vorgebbaren gewünschten und vor dem Betrieb der Membran eingestellten Zustand zu groß, ist ein fehlerfreier Betrieb nicht mehr möglich, so dass eine Unterbrechung des Betriebs und eine aufwendige neue Einstellung erforderlich werden.

Daher liegt der vorliegenden Erfindung die Aufgabe zugrunde, ein Verfahren zum Betreiben eines Bauteils zur Verfügung zu stellen, welches eine Kompensation einer ungewünschten Zustandsänderung in einfacher Weise ermöglicht.

Die zuvor hergeleitete und aufgezeigte Aufgabe wird gemäß einem ersten Aspekt der Erfindung bei einem Verfahren zum Betreiben eines Bauteils gelöst. Das zu betreibende Bauteil weist mindestens eine elektromechanische Wandlereinrichtung umfassend mindestens eine zwischen einer ersten Elektrode und mindestens einer zweiten Elektrode angeordnete elektroaktive Schicht auf. Das Verfahren umfasst die Schritte:
- Einstellen eines vorgebbaren Zustands des Bauteils vor dem Betreiben des Bauteils, wobei mindestens ein erster Parameterwert eines den vorgebbaren Zustand bestimmenden ersten Parameters als erster Sollwert bestimmt wird,
- Erfassen eines Istwertes des ersten Parameters während des Betriebs des Bauteils,
- Vergleichen des erfassten Istwertes des ersten Parameters mit dem bestimmten Sollwert des ersten Parameters, und
- Anlegen eines elektrischen Signals an die erste Elektrode und die mindestens zweite Elektrode bei Detektion einer vorgebbaren Abweichung des Istwertes des ersten Parameters von dem Sollwert des ersten Parameters, derart, dass die Abweichung des Istwertes des ersten Parameters von dem Sollwert des ersten Parameters zumindest reduziert wird.

Im Gegensatz zum Stand der Technik wird gemäß der Lehre der Erfindung eine Kompensation einer ungewünschten Zustandsänderung eines mindestens eine elektromechanische Wandlereinrichtung aufweisenden Bauteils dadurch ermöglicht, dass der Zustand des Bauteils während des Betriebs des Bauteils überwacht wird und eine ungewünschte Zustandsänderung durch Beaufschlagung der elektromechanischen Wandlereinrichtung mit einem entsprechenden elektrischen Signal zumindest reduziert werden kann.

Bei dem zu betreibenden Bauteil kann es sich um ein beliebiges Bauteil handeln, welches während des Betriebs einen vorgebbaren Zustand aufweisen muss. Erfindungsgemäß weist das Bauteil mindestens eine elektromechanische Wandlereinrichtung auf. Es versteht sich, dass das Bauteil auch zwei oder mehr elektromechanische Wandlereinrichtungen aufweisen kann. Die elektromechanische Wandlereinrichtung umfasst mindestens eine elektroaktive Schicht. Dessen äußere Oberflächen können mit jeweils einer Elektrode bevorzugt unmittelbar kontaktiert, beispielsweise beschichtet, sein. An der Oberseite der elektroaktiven Schicht kann eine elektrisch leitfähige Schicht angeordnet sein. Ebenso kann an der Unterseite der elektroaktiven Schicht eine elektrisch leitfähige Schicht angeordnet sein. Es versteht sich, dass die Unterseite bzw. die Oberseite nur teilweise bzw. abschnittsweise mit einer elektrisch leitfähigen Schicht beschichtet sein kann. Beispielsweise kann eine strukturierte bzw. segmentierte Schicht gebildet werden. Vorzugsweise kann eine elektrisch leitfähige Schicht aus einem Material gebildet sein, das ausgewählt ist aus der Gruppe umfassend Metalle, Metalllegierungen, leitfähige Oligo- oder Polymere, leitfähige Oxide und/oder mit leitfähigen Füllstoffen gefüllte Polymere.

Vor einem Betrieb des Bauteils wird ein vorgebbarer Zustand, insbesondere eine Position und/oder eine Form des Bauteils, eingestellt. Dies kann mittels der elektromechanischen Wandlereinrichtung und/oder anderen Aktuatoren erfolgen.

Nach einer Einstellung des vorgebbaren Zustands kann zumindest der Parameterwert eines Parameters, der den Zustand zumindest mitbestimmt, bestimmt werden. Der Parameter kann also Aufschluss über den aktuellen Zustand des Bauteils geben. Beispielsweise kann der Parameterwert aus den Einstellungsdaten, die für die Einstellung des vorgebbaren Zustands verwendet wurden, abgeleitet werden. Zusätzlich oder alternativ sind eine rechnerische Bestimmung und/oder eine messtechnische Bestimmung möglich. Der bestimmte Parameterwert wird als Sollwert festgelegt und kann beispielsweise in einer geeigneten Speichereinrichtung gespeichert werden.

Während des Betriebs kann der Istwert des ersten Parameters insbesondere durch eine geeignete Erfassungseinrichtung erfasst werden. Beispielsweise kann ein oder mehrere Sensoren, die zur Erfassung des Parameters geeignet sind, verwendet werden.

Der erfasste Istwert wird dann mit dem Sollwert beispielsweise in einer Vergleichseinrichtung verglichen. Insbesondere kann überprüft bzw. detektiert werden, ob eine vorgebbare Abweichung zwischen dem Istwert und dem Sollwert vorliegt. Beispielsweise kann für den Sollwert mindestens ein Grenzwert, wie ein oberer und/oder unterer Grenzwert, vorgeben werden. Wird beispielsweise durch die Vergleichseinrichtung festgestellt, dass die Abweichung außerhalb einer zulässigen Abweichung, bei der weiterhin ein zuverlässiger und fehlerfreier Betrieb des Bauteils gewährleistet werden kann, festgestellt, so kann die elektromechanische Wandlereinrichtung angesteuert werden. Insbesondere kann ein elektrisches Signal an die Elektroden, also beispielsweise eine gewünschte Spannungsänderung zwischen den Elektroden, erzeugt werden. Durch das entsprechende elektrische Signal wird eine Zustandsänderung, wie eine Positions- und/oder Formänderung der elektroaktiven Wandlereinrichtung und somit des Bauteils bewirkt. Die während des Betriebs beispielsweise aufgrund von Feuchtigkeits-, Druck- und/oder Temperaturschwankungen aufgetretene unzulässige Zustandsänderung kann zumindest reduziert werden. Bevorzugt wird die Zustandsänderung zumindest derart reduziert, dass die Abweichung des Istwerts von dem Sollwert zumindest wieder in dem vorgebbaren zulässigen Bereich liegt.

Zur Erzeugung des elektrischen Signals kann eine geeignete Steuereinrichtung vorgesehen sein, die beispielsweise aus der detektierten Abweichung ein entsprechendes Signal ableiten, berechnen oder in ähnlicher Weise bestimmen kann.

Es versteht sich, dass auch zwei oder mehr Bauteile betrieben und ungewünschte Zustandsänderungen kompensiert werden können.

In einer ersten Ausführungsform kann vorgesehen sein, dass der Istwert des ersten Parameters während des Betriebs des Bauteils in vorgebbaren Zeitabständen erfasst wird. Insbesondere kann vorgesehen sein, dass der Istwert periodisch erfasst wird. Für eine besonders zeitnahe Kompensation kann auch eine (nahezu) kontinuierliche Erfassung durchgeführt werden. Vorzugsweise wird jeder erfasste Istwert mit dem Sollwert verglichen. Eine ungewünschte Zustandsänderung während des Betriebs kann insbesondere rechtzeitig erkannt und ausgeglichen werden, ohne dass der Betrieb des Bauteils beeinträchtigt wird.

Als elektroaktive Schichten können verschiedene Materialien bzw. Schichten eingesetzt werden. Insbesondere kann die Wahl des Materials vom späteren Einsatzzweck abhängen. Beispielhafte elektroaktive Schichten sind Piezoschichten, elektrostriktive Polymerschichten, flüssigkristalline Elastomerschichten und dergleichen. Gemäß einer bevorzugten Ausführungsform der vorliegenden Erfindung kann die mindestens eine elektroaktive Schicht eine dielektrische Elastomerschicht sein. Insbesondere kann die dielektrische Elastomerschicht eine dielektrische Elastomerfolie sein. Eine dielektrische Elastomerschicht weist vorzugsweise eine relativ hohe Dielektrizitätszahl auf. Darüber hinaus weist eine dielektrische Elastomerschicht vorzugsweise eine niedrige mechanische Steifigkeit auf. Diese Eigenschaften führen zu möglichen Dehnungswerten von bis zu ca. 300 %. Eine dielektrische Elastomerschicht kann insbesondere für eine Aktuatoranwendung eingesetzt werden. Jedoch eignet sich eine dielektrische Elastomerschicht ebenso für Sensor- oder Generatoranwendungen. Bei mehreren elektroaktiven Schichten können diese bevorzugt aus dem gleichen Material gebildet sein.

Ferner kann die dielektrische Elastomerschicht gemäß einer bevorzugten Ausführungsform der Erfindung ein Material umfassen, das beispielsweise ausgewählt ist aus der Gruppe umfassend Polyurethan-Elastomere, Silikon-Elastomere und/oder Acrylat-Elastomere.

Vorzugsweise kann eine vorgebbare Position und/oder vorgebbare Form des Bauteils eingestellt werden. Durch die mindestens eine elektromechanische Wandlereinrichtung kann zumindest die Form und/oder die Position des Bauteils bevorzugt in beliebiger Weise geändert werden. So kann sich eine elektroaktive Schicht zumindest in eine Richtung ausdehnen oder zusammenziehen. Bei einer dielektrischen Elastomerschicht kann das Volumen der Schicht in Folge einer Beaufschlagung mit einem elektrischen Feld im Wesentlichen konstant bleiben. Beispielsweise kann sich bei einem konstanten Volumen die Dicke verringern und gleichzeitig die Fläche vergrößern. Bei einer Ferroelektretfolie kann sich im Wesentlichen (lediglich) die Dicke der Schicht ändern. Durch die Anordnung von strukturierten Elektroden können zudem aktive und passive Bereiche geschaffen werden, um in bestimmten Bereichen eine gezielte Formänderung zu bewirken. Es versteht sich, dass eine Mehrzahl an Aktuatoren, insbesondere an elektromechanischen Aktuatoren, vorgesehen sein kann, um eine exakte Position und/oder Form des Bauteils einzustellen.

Gemäß einer weiteren Ausführungsform kann während des Betriebs des Bauteils der vorgebbare Zustand geändert werden. Hierbei handelt es sich um eine gezielte, also gewünschte, Zustandsänderung des Bauteils. Beispielsweise kann während des Betriebs eine Positions- und/oder Formänderung für den Betrieb erforderlich sein. Die Änderungen hängen insbesondere von der Anwendung ab. Beispielsweise können diskrete oder kontinuierliche Zustandsänderungen erforderlich sein. Nach jeder Zustandsänderung kann insbesondere mindestens der erste Parameterwert des den geänderten Zustand bestimmenden ersten Parameters als Sollwert bestimmt werden. Eine Zustandsänderung kann eine Änderung des Sollparameters mit sich bringen. Nach einer geänderten Zustandsänderung kann der neue Sollwert, wie zuvor bereits beschrieben wurde, bestimmt werden. Der neue Sollwert kann in zuvor beschriebener Weise für die Vergleichsfunktion zur Feststellung einer ungewünschten Abweichung des mindestens einen Parameters eingesetzt werden. Es ist keine Unterbrechung und/oder aufwendige Neueinstellung des Zustands erforderlich. Weiterhin kann eine ungewünschte Zustandsänderung zeitnah erkannt und insbesondere kompensiert werden.

Der vorgebbare Zustand kann von einer Mehrzahl unterschiedlicher Parameter bestimmt sein. Gemäß einer bevorzugten Ausführungsform des erfindungsgemäßen Verfahrens kann mindestens ein weiterer Parameterwert eines den vorgebbaren Zustand bestimmenden weiteren Parameters als weiterer Sollwert bestimmt werden. Ein Istwert des weiteren Parameters kann während des Betriebs des Bauteils erfasst werden. Der erfasste Istwert des weiteren Parameters kann mit dem bestimmten Sollwert des weiteren Parameters verglichen werden. Ein elektrisches Signal kann an die erste Elektrode und die mindestens zweite Elektrode bei Detektion einer vorgebbaren Abweichung des Istwertes des weiteren Parameters von dem Sollwert des weiteren Parameters angelegt werden, derart, dass die Abweichung des Istwertes des weiteren Parameters von dem Sollwert des weiteren Parameters zumindest reduziert wird. Es versteht sich, dass eine Vielzahl an Parametern, die den Zustand des Bauteils repräsentieren und/oder ihn beeinflussen, (gleichzeitig) überwacht werden kann. Eine besonders genaue und zeitnahe Kompensation von ungewünschten Zustandsänderungen des Bauteils kann erzielt werden.

Gemäß einer weiteren Ausführungsform der Erfindung kann der mindestens eine Parameter ausgewählt sein aus der Gruppe geometrischer Parameter, Gewichtsparameter, Feuchtigkeitsparameter und/oder Temperaturparameter. Beispielsweise kann eine Form und/oder Position, insbesondere eine geometrische Form des Bauteils durch geometrische Parameter, wie Breite, Dicke, Höhe, Länge, Krümmung, Abstand, etc., bestimmt sein. Auch kann die Form und/oder Position durch Parameter beeinflusst sein. Beispielhafte weitere Parameter sind die Temperatur des Bauteils und/oder der Umgebung, das Gewicht des Bauteils, der Umgebungsdruck und/oder die Feuchtigkeit des Bauteils und/oder der Umgebung. Eine erfasste Temperaturänderung kann beispielsweise die Ausdehnung des Bauteils ändern. Bei Detektion einer Temperaturabweichung kann beispielsweise eine aus dieser Temperaturabweichung hervorgehende Zustandsänderung abgeleitet, berechnet oder aus gespeicherten Tabellen bestimmt werden. Dann kann zur Kompensation der ungewünschten Zustandsänderung eine Änderung des elektrischen Signals bewirkt werden.

Ein weiterer Aspekt der Erfindung ist ein System insbesondere zur Durchführung des zuvor beschriebenen Verfahrens. Das System umfasst mindestens ein zu betreibendes Bauteil, wobei das Bauteil mindestens eine elektromechanische Wandlereinrichtung umfassend mindestens eine zwischen einer ersten Elektrode und mindestens einer zweiten Elektrode angeordnete elektroaktive Schicht aufweist, mindestens eine Stelleinrichtung konfiguriert zum Einstellen eines vorgebbaren Zustands des Bauteils zum Betreiben des Bauteils, wobei mindestens ein erster Parameterwert eines den vorgebbaren Zustand bestimmenden ersten Parameters als erster Sollwert bestimmt wird, mindestens eine Erfassungseinrichtung konfiguriert zum Erfassen eines Istwertes des ersten Parameters während des Betriebs des Bauteils, mindestens eine Vergleichseinrichtung konfiguriert zum Vergleichen des erfassten Istwertes des ersten Parameters mit dem bestimmten Sollwert des ersten Parameters, und mindestens eine Steuereinrichtung konfiguriert zum Anlegen eines elektrischen Signals an die erste Elektrode und die mindestens zweite Elektrode bei Detektion einer vorgebbaren Abweichung des Istwertes des ersten Parameters von dem Sollwert des ersten Parameters, derart, dass die Abweichung des Istwertes des ersten Parameters von dem Sollwert des ersten Parameters zumindest reduziert wird.

Die Stelleinrichtung kann beispielsweise eine elektrische und/oder mechanische Stelleinrichtung zum Einstellen des vorgebbaren Zustands sein. Vor dem Betrieb kann dann in zuvor beschriebener Weise mindestens ein Sollparameter bestimmt werden. Während des Betriebs des Bauteils wird mindestens ein Istwert des mindestens einen Parameters beispielsweise in vorgebbaren Zeitabständen durch mindestens eine Erfassungseinrichtung erfasst. Die Erfassungseinrichtung kann mindestens einen geeigneten Sensor zur Erfassung aufweisen. Der erfasste Parameter kann an eine Vergleichseinrichtung in geeigneter Weise übertragen werden. Beispielsweise kann der Vergleichseinrichtung ein geeigneter digitaler oder analoger Wert zur Verfügung gestellt werden. Die Vergleichseinrichtung ist dazu eingerichtet, den Istwert mit dem Sollwert und/oder vorgebbaren Grenzwerten des Sollwerts zu vergleichen. Bei Detektion einer Abweichung, also beispielsweise eine Übereinstimmung des Istwerts mit einem vorgebbaren Grenzwert, ist eine Steuereinrichtung dazu eingerichtet, die elektromechanische Wandlereinrichtung des Bauteils mit einem elektrischen Signal zu beaufschlagen. Insbesondere kann ein anliegendes elektrisches Signal geändert werden. Beispielsweise kann die Steuereinrichtung eine steuerbare Energiequelle aufweisen oder mit einer verbunden sein. Insbesondere kann zur Kompensation der ungewünschten Zustandsänderung eine Spannungsänderung generiert werden. In einfacher Weise und ohne Unterbrechung des Betriebs des Bauteils können ungewünschten Zustandsänderung kompensiert werden.

Gemäß einer ersten Ausführungsform des erfindungsgemäßen Systems kann das Bauteil an mindestens einer Halteeinrichtung befestigt sein. Es versteht sich, dass eine Mehrzahl an Halteeinrichtungen vorgesehen sein kann. Beispielsweise kann ein Ständer oder Verbindungsmittel zum Befestigen des Bauteils an einer Trägerstruktur, wie einer Wand oder dergleichen, vorgesehen sein. Vorzugsweise kann die Halteeinrichtung mindestens eine weitere elektromechanische Wandlereinrichtung umfassend mindestens eine zwischen einer ersten Elektrode und mindestens einer zweiten Elektrodeangeordnete elektroaktive Schicht aufweisen. Mit der mindestens einen weiteren elektromechanischen Wandlereinrichtung kann die Form und/oder die Position des Bauteils besonders exakt eingestellt werden. Beispielsweise kann die Position des Bauteils im Raum, wie die Höhe des Bauteils, gezielt geändert werden.

Gemäß einer bevorzugten Ausführungsform kann die mindestens eine Steuereinrichtung konfiguriert sein zum Anlegen eines elektrischen Signals an die erste Elektrode und die mindestens zweite Elektrode der weiteren elektromechanischen Wandlereinrichtung bei Detektion einer vorgebbaren Abweichung des Istwertes des ersten Parameters von dem Sollwert des ersten Parameters, derart, dass die Abweichung des Istwertes des ersten Parameters von dem Sollwert des ersten Parameters zumindest reduziert wird. Bei Detektion einer Abweichung kann die Steuereinrichtung insbesondere die erste und/oder die weitere elektromechanische Wandlereinrichtung zum Kompensieren der Zustandsänderung entsprechend ansteuern. Es versteht sich, dass eine Vielzahl an elektromechanischen Wandlereinrichtungen zur Kompensation von (nahezu) jeder ungewünschten Form- und/oder Positionsänderung vorgesehen sein kann. Grundsätzlich kann eine elektromechanische Wandlereinrichtung, welche mindestens eine zwischen zwei Elektroden angeordnete elektroaktive Schicht aufweist, beliebig ausgebildet sein. Vorzugsweise kann mindestens eine elektromechanische Wandlereinrichtung als gerollter elektromechanischer Aktuator ausgebildet sein. Ein gerollter elektromechanischer Aktuator zeichnet sich dadurch aus, dass sich bei der Aktivierung eine Kraft und eine Dehnung in axialer Richtung einstellt, also eine Formänderung in axialer Richtung ermöglicht wird. Beispielsweise kann eine mit Elektroden beschichtete Elastomerfolie um eine Achse herum aufgerollt werden. Alternativ kann die mindestens eine elektromechanische Wandlereinrichtung als gestapelter elektromechanischer Aktuator ausgebildet sein. Ein gestapelter elektromechanischer Aktuator weist mindestens eine, bevorzugt eine Mehrzahl an planaren Aktuatoren auf, also einen Aktuator, der z.B. eine mit zwei Elektroden beschichtete Elastomerfolie umfasst. Durch die Verwendung unterschiedlicher Aktuatoren kann in einfacher Weise eine Kompensation einer ungewünschten Form- und/oder Positionsänderung durchgeführt werden.

Wie bereits beschrieben wurde, kann es sich bei dem zu betreibenden Bauteil um ein beliebiges Bauteil handeln, welches während des Betriebs des Bauteils ungewünschten Zustandsänderungen unterliegt. Gemäß einer bevorzugten Ausführungsform kann das Bauteil ein optisches Bauteil sein. Insbesondere kann es ein Hohlspiegel sein. Der Hohlspiegel kann zumindest eine elektromechanische Wandlereinrichtung umfassen. Insbesondere kann der Hohlspiegel durch die elektromechanische Wandlereinrichtung gebildet werden. Der Hohlspiegel kann insbesondere seine flächenmäßige Ausdehnung in Abhängigkeit eines elektrischen Signals, wie einer elektrischen Spannung, ändern. Durch die Formänderung kann beispielsweise eine gewünschte Brennweite eingestellt werden. Um die Brennweite während des Betriebs des Hohlspiegels konstant zu halten, kann es erforderlich sein, ungewollte Zustandsänderung, beispielsweise aufgrund von Temperatur-Druck- und/oder Feuchtigkeitsänderungen, durch das anliegende elektrische Signal nachzuregeln.

Ein weiterer Aspekt der Erfindung ist eine Verwendung des zuvor beschriebenen Systems zum Kompensieren von mindestens einer Zustandsänderung eines Bauteils während des Betriebs des Bauteils.

Ein noch weiterer Aspekt der Erfindung ist ein Scheinwerfer umfassend das zuvor beschriebene System. Beispielsweise kann der Scheinwerfer in einem Fahrzeug, wie einem Kraftfahrzeug oder einem Schienenfahrzeug, eingesetzt werden. Insbesondere kann das Bauteil ein durch eine oder mehrere Lichtquellen anstrahlbarer und einstellbarer Hohlspiegel sein.

Es gibt nun eine Vielzahl von Möglichkeiten, das erfindungsgemäße Verfahren, das erfindungsgemäße System, die erfindungsgemäße Verwendung sowie den erfindungsgemäßen Scheinwerfer auszugestalten und weiterzuentwickeln. Hierzu sei einerseits verwiesen auf die den unabhängigen Patentansprüchen nachgeordneten Patentansprüche, andererseits auf die Beschreibung von Ausführungsbeispielen in Verbindung mit der Zeichnung. In der Zeichnung zeigt:
- Fig. 1: eine schematische Ansicht eines ersten Ausführungsbeispiels eines Systems gemäß der vorliegenden Erfindung;
- Fig. 2: eine schematische Ansicht eines weiteren Ausführungsbeispiels eines Systems gemäß der vorliegenden Erfindung; und
- Fig. 3: ein Flussdiagramm eines Ausführungsbeispiels eines Verfahrens gemäß der vorliegenden Erfindung.

Nachfolgend werden gleiche Bezugszeichen für gleiche Elemente verwendet.

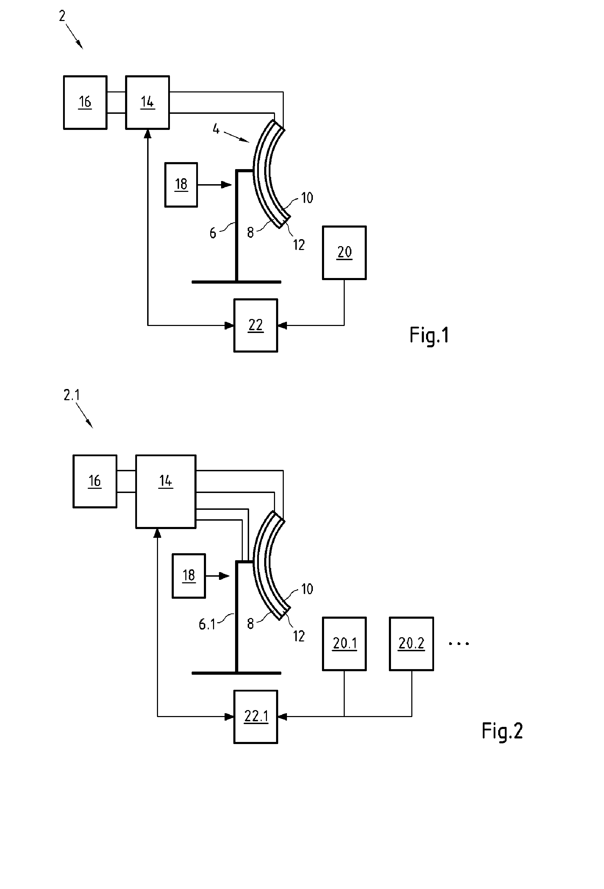

Figur 1 zeigt ein erstes Ausführungsbeispiel eines Systems 2 gemäß der vorliegenden Erfindung. Das System 2 umfasst im vorliegenden Ausführungsbeispiel ein erstes Bauteil 4, welches während des Betriebs des Bauteils 4 in einem gleichbleibenden Zustand gehalten werden kann.

Bei dem Bauteil 4 handelt es sich im vorliegenden Ausführungsbeispiel um ein vereinfacht dargestelltes optisches Bauelement 4. Das optische Bauelement 4 ist insbesondere ein an einer Halteeinrichtung 6 angeordneter Hohlspiegel 4. Ein derartiger Hohlspiegel 4 kann beispielsweise in einem Autoscheinwerfer oder in einer Solarthermieanlage, beispielsweise als Parabolrinnenkollektor, eingesetzt werden. Es versteht sich, dass es grundsätzlich eine Vielzahl an Anwendungsmöglichkeiten für ein optisches Bauelement gibt und die Erfindung nicht auf optische Bauelemente beschränkt ist.

Der vereinfacht dargestellte Hohlspiegel 4 weist vorliegend eine elektromechanische Wandlereinrichtung auf. Insbesondere kann der beispielhafte Hohlspiegel im Wesentlichen vollständig durch die elektromechanische Wandlereinrichtung gebildet sein. Der Hohlspiegel 4 weist eine zwischen einer ersten Elektrode 8 und einer zweiten Elektrode 10 angeordnete elektroaktive Schicht 12 auf. Die Elektroden 8, 10 können als elektrisch leitfähige Schichten 8, 10 ausgebildet sein. Insbesondere können die Elektroden 8, 10 die elektroaktive Schicht 12 unmittelbar zumindest teilweise kontaktieren. Es versteht sich, dass die Unterseite bzw. die Oberseite des der elektroaktiven Schicht 12 nur teilweise mit einer elektrisch leitfähigen Schicht 8, 10 beschichtet sein kann. Beispielsweise kann mindestens eine strukturierte Elektrode 8, 10 aufgedruckt sein. Vorzugsweise kann eine elektrisch leitfähige Schicht 8, 10 aus einem Material gebildet sein, das ausgewählt ist aus der Gruppe umfassend Metalle, Metalllegierungen, leitfähige Oligo- oder Polymere, leitfähige Oxide und/oder mit leitfähigen Füllstoffen gefüllte Polymere.

Vorzugsweise ist die zweite Elektrode 10 aus einem Material mit reflektierenden Eigenschaften gebildet. Mit anderen Worten kann die zweite Elektrode nicht nur als Elektrode, sondern auch als reflektierende Oberfläche dienen. Es versteht sich, dass gemäß anderen Varianten der vorliegenden Erfindung die zweite Elektrode 12 auch mit einer zusätzlichen Reflektionsschicht beschichtet sein kann. Darüber hinaus versteht es sich, dass das Bauteil 4 auch mehr als eine elektroaktive Schicht 12, beispielsweise zwei oder mehr elektroaktive Schichten, aufweisen kann, wobei bevorzugt zwischen sämtlichen elektroaktiven Schichten zumindest teilweise eine elektrisch leitfähige Schicht vorgesehen sein kann.

Bevorzugt kann als elektroaktive Schicht 12 eine dielektrische Elastomerschicht 12, wie eine dielektrische Elastomerfolie, eingesetzt werden. Eine dielektrische Elastomerschicht 12 weist vorteilhafterweise eine relativ hohe Dielektrizitätszahl auf. Darüber hinaus weist eine dielektrische Elastomerschicht 12 vorteilhafterweise eine niedrige mechanische Steifigkeit auf. Dies führt zu möglichen Dehnungswerten von bis zu ca. 300 %. Eine dielektrische Elastomerschicht 12 kann insbesondere für eine Aktuatoranwendung eingesetzt werden. Wird an den zumindest zwei Elektroden 8, 10 beispielsweise die anliegende Spannung geändert, so ändert sich die Form der elektroaktiven Wandlereinrichtung entsprechend.

Es versteht sich, dass auch andere elektroaktive Schichten verwendet werden können, wie Piezoschichten, elektrostriktive Polymerschichten, flüssigkristalline Elastomerschichten, etc.

Die Dehnfähigkeit der elektroaktiven Schicht 12 kann jedoch durch weitere Schichten, die die elektroaktiven Schichten kontaktieren, beschränkt sein. Um beispielsweise bei einer dielektrischen Schicht eine Ausdehnung nicht nur in Dickenrichtung, sondern auch in eine Längsrichtung und/oder in eine Querrichtung zu ermöglichen, kann es erforderlich sein, dass die Elektroden 8, 10 dehnfähig ausgebildet sind. Beispielsweise können entsprechend nachgiebige Materialien eingesetzt werden, also Materialien, welche eine geringe Steifigkeit aufweisen. Beispielhafte nachgiebige Materialien sind mit elektrisch leitfähigen Füllstoffen gefüllte Elastomere.

Um auch steife Materialien einsetzen zu können, kann vorteilhafterweise mindestens eine Elektrode 8, 10 ein wellenförmiges Querschnittsprofil aufweisen. Eine Elektrode 8, 10 kann insbesondere entlang wenigstens einer Richtung ein wellenförmiges Querschnittsprofil aufweisen. Ein wellenförmiges Querschnittsprofil weist Erhebungen und Senkungen auf, welche bevorzugt in einer im Wesentlichen gleichmäßigen Abfolge angeordnet sein können. Es versteht sich, dass auch andere Abfolgen vorgesehen sein können, die sich insbesondere an der späteren Anwendung orientieren können. Bei einer Dehnung wird das wellenförmige Querschnittsprofil gestreckt und so eine Dehnfähigkeit in mindestens eine Richtung erhöht.

Wie bereits ausgeführt wurde, ist im vorliegenden Ausführungsbeispiel das Bauteil 4 aus der elektromechanischen Wandlereinrichtung umfassend die erste und die zweite Elektrode 8, 10 sowie die elektroaktive Schicht 12 gebildet. Es versteht sich, dass das Bauteil 4 auch nur teilweise aus einer elektromechanischen Wandlereinrichtung gebildet sein kann und/oder zwei oder mehr separate elektromechanische Wandlereinrichtungen aufweisen kann.

Mit den zumindest zwei Elektroden 8, 10 der elektromechanischen Wandlereinrichtung kann eine Steuereinrichtung 14 elektrisch verbunden sein. Die Steuereinrichtung 14 kann beispielsweise mit einer Energieversorgung 16, wie einer steuerbaren Energiequelle, verbunden sein. Beispielsweise kann eine Batterie oder ein Netzanschluss vorgesehen sein. Die Steuereinrichtung 14 ist dazu eingerichtet, an die Elektroden 8, 10 ein elektrisches Signal, beispielsweise eine elektrische Spannung, anzulegen. Die Steuereinrichtung 14 kann geeignete Mittel, wie einen Prozessor, Speichermittel, Schnittstellen und dergleichen umfassen.

Darüber hinaus kann eine Stelleinrichtung 18 zum Einstellen eines vorgebbaren Zustands des Bauteils 4 vorgesehen sein. Unter dem Zustand des Bauteils 4 ist/sind insbesondere dessen geometrische Form und/oder dessen Position zu verstehen. Die Stelleinrichtung 18 kann Steuermittel aufweisen und mit einem oder mehreren Aktuatoren verbunden sein oder diese aufweisen. Mit den beispielsweise mechanischen, elektrischen und/oder elektromechanischen Aktuatoren kann ein Zustand, insbesondere ein vorgebbarer Grundzustand, generiert werden.

Es versteht sich, dass die Stelleinrichtung 18 und die Steuereinrichtung 14 in einem Bauteil ausgeführt sein können. Die Steuereinrichtung 14 kann beispielsweise die Funktion der Stelleinrichtung 18 übernehmen und ein Einstellen eines vorgebbaren Zustands des Bauteils 4 zum Betreiben des Bauteils 4 bewirken. Insbesondere kann die mindestens eine elektromechanische Wandlereinrichtung mit einem entsprechenden elektrischen Signal beaufschlagt werden.

Darüber hinaus umfasst das vorliegende System 2 eine Erfassungseinrichtung 20. Die Erfassungseinrichtung 20 weist eine oder mehrere Sensoren zum Erfassen von mindestens einem ersten Parameter auf. Als Sensor kann ein geeigneter aktiver oder passiver Sensor, wie ein optischer Sensor, ein thermischer Sensor, ein Feuchtigkeitssensor oder dergleichen, eingesetzt werden.

Der Sensor bzw. die Erfassungseinrichtung 20 ist insbesondere dazu eingerichtet, mindestens einen ersten Parameter bzw. den Wert eines ersten Parameters zu ermitteln. Bei dem Parameter handelt es sich insbesondere um einen den Zustand des Bauteils 4 bestimmender Parameter. Beispielsweise ist der mindestens eine Parameter ein geometrischer Parameter des Bauteils 4, wie die Länge, Breite, Krümmung und/oder Dicke des Bauteils, und/oder ein Parameter, wie die Feuchtigkeit und/oder die Temperatur des Bauteils 4 und/oder die Feuchtigkeit und/oder die Temperatur der Umgebung des Bauteils 4.

Mit der Erfassungseinrichtung 20 ist ferner eine Vergleichseinrichtung 22 verbunden. Die Vergleichseinrichtung 22 kann in beliebige Weise ausgebildet sein und beispielsweise einen Vergleich eines Istparameterwertes mit einem Sollparameterwert in analoger oder digitaler Form ermöglichen. Beispielsweise kann ein Sollparameter bzw. Sollparameterwert in einer Speichereinrichtung der Vergleichseinrichtung speicherbar oder gespeichert sein. Insbesondere ist die Vergleichseinrichtung 22 eingerichtet, um mindestens einen von der Erfassungseinrichtung 20 erfassten Parameterwert mit einem zuvor bestimmten Parameterwert zu vergleichen.

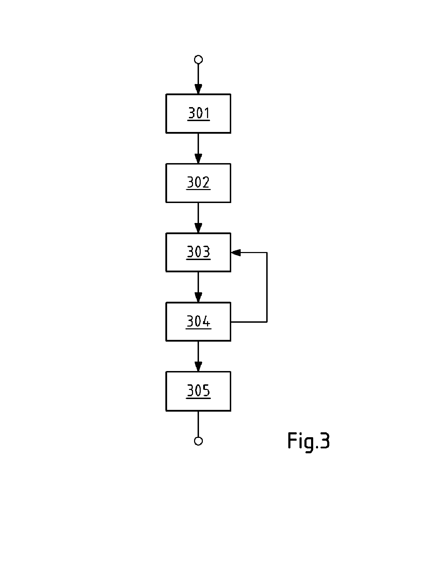

Des Weiteren ist die Vergleichseinrichtung 22 mit der Steuereinrichtung 14 verbunden. Es versteht sich, dass gemäß anderen Varianten der Erfindung die Vergleichseinrichtung 22 in der Steuereinrichtung 14 und/oder der Erfassungseinrichtung 20 integriert sein kann. Die Funktionsweise des Systems 2 wird nachfolgend mit Hilfe der Figur 3 näher erläutert.

Es sei angemerkt, dass die Elemente 14, 16, 18, 22 und/oder 20 in einer (einzigen) Einrichtung zumindest teilweise integriert sein können.

Bevor die Funktionsweise des Systems 2 näher erläutert wird, wird zunächst auf die Figur 2 eingegangen. Die Figur 2 zeigt ein weiteres Ausführungsbeispiel eines erfindungsgemäßen Systems 2.1. Zur Vermeidung von Wiederholungen werden nachfolgend insbesondere die Unterschiede des Systems 2.1 gemäß Figur 2 im Vergleich zum System 2 gemäß Figur 1 erläutert.

Der Figur 2 kann entnommen werden, dass das System 2.1 eine erste und mindestens eine weitere Erfassungseinrichtung 20.1, 20.2 aufweist. Durch mehrere Erfassungseinrichtungen 20.1, 20.2 können insbesondere in einfacher Weise eine Mehrzahl an unterschiedlichen Parametern erfasst werden. Beispielsweise kann die Erfassungseinrichtung 20.1 mittels eines Temperatursensors die Temperatur des Bauteils 4 und die Erfassungseinrichtung 20.2 mittels eines optischen Sensors die Form des Bauteils 4, wie die Krümmung des Hohlspiegels 4, erfassen.

Die Vergleichseinrichtung 22.1 kann insbesondere dazu eingerichtet sein, die zumindest zwei erfassbaren Parameter, also deren Istwerte, mit vorgebbaren und/oder gespeicherten Sollparameterwerten zu vergleichen.

Ferner ist eine einstellbare Halteeinrichtung 6.1 vorgesehen. Die Halteeinrichtung 6.1 kann vorzugsweise zumindest teilweise aus einer elektromechanischen Wandlereinrichtung umfassend mindestens eine zwischen einer ersten Elektrode und einer zweiten Elektrode angeordnete elektroaktive Schicht gebildet sein. Beispielsweise kann ein gerollter Aktuator mit einer stabförmigen Form vorgesehen sein, welcher zumindest eine Einstellung in Abhängigkeit eines elektrischen Signals in axialer Richtung ermöglicht. Beispielsweise kann die Position des Hohlspiegels 4 in axialer Richtung eingestellt werden. Es versteht sich, dass gemäß anderen Varianten der Erfindung weitere elektromechanische Wandlereinrichtungen zur Einstellung in mehrere Richtungen vorgesehen sein können. Die Halteeinrichtung 6.1, insbesondere die zumindest zwei Elektroden der elektromechanischen Wandlereinrichtung, kann elektrisch mit der Steuereinrichtung 14 verbunden sein.

Gemäß einem weiteren Ausführungsbeispiel kann das Bauteil 4, 4.1 eine passive Schicht aufweisen. Beispielsweise kann an der nicht mit der elektroaktiven Schicht 12 in Kontakt stehenden Oberfläche der Elektrode 8 oder der Elektrode 10 eine passive Schicht angebracht sein. Bevorzugt kann die passive Schicht zumindest weniger dehnfähig als die Elektroden 8, 10, insbesondere nahezu nicht dehnfähig bzw. unnachgiebig, ausgebildet sein.

Wird an die Elektroden 8, 10 ein elektrisches Signal angelegt, so dehnt sich die elektroaktive Schicht 12 entsprechend aus. Aufgrund der vorzugsweise unnachgiebig ausgebildeten passiven Schicht, die an (lediglich) einer Elektrode 8, 10, bevorzugt an der Elektrode 10, angeordnet ist, wird eine Ausdehnung an dieser einen Elektrode 8, 10 verhindert, so dass eine asymmetrische Ausdehnung des Bauteils 4, 4.1 erfolgt. Beispielsweise kann eine gewünschte Krümmung des Bauteils 4, 4.1 erzielt werden, ohne dass eine spezielle Strukturierung der Elektroden 8,10 erforderlich ist. Ferner kann die passive Schicht gleichzeitig als reflektierende Schicht ausgebildet sein.

Nachfolgend wird die Funktionsweise des Systems 2 gemäß der Figur 1 anhand der Figur 3 näher erläutert. Die Figur 3 zeigt ein Flussdiagramm eines Verfahrens zum Betreiben eines Bauteils 4 insbesondere mittels des Systems 2 gemäß Figur 1.

In einem ersten Schritt 301 kann ein vorgebbarer Zustand des Bauteils 4 mittels der Einstelleinrichtung 18 und/oder der Steuereinrichtung 14 eingestellt werden. Grundsätzlich ist sogar eine manuelle Einstellung möglich.

Der vorgebbare Zustand des Bauteils 4 hängt insbesondere von der Anwendung des Bauteils 4 ab. Beispielsweise kann der Hohlspiegel 4 in eine geeignete Position durch mindestens einen geeigneten Aktuator gebracht werden. Bevorzugt können zumindest teilweise elektromechanische Aktuatoren verwendet werden.

Ferner kann die Form des Hohlspiegels 4 entsprechend den Erfordernissen einer Anwendung eingestellt werden. Die Form des Hohlspiegels 4 kann insbesondere von einer gewünschten Brennweite abhängen. So kann der Hohlspiegel 4 plan, konkav oder konvex mit einer bestimmten Krümmung eingestellt werden. Beispielsweise ist der Hohlspiegel 4 dazu vorgesehen, Lichtstrahlen einer (nicht dargestellten) Lichtquelle auf eine (nicht dargestellte) Lochblende zu fokussieren. Die Einstellung der Form kann insbesondere mittels der mindestens einen elektroaktiven Wandlereinrichtung des Bauteils 4 durchgeführt werden. Beispielsweise kann die Steuereinrichtung 14 ein entsprechendes elektrisches Signal an die Elektroden 8, 10 anlegen. Es können strukturierte Elektroden 8, 10 mit passiven und aktiven Bereichen vorgesehen sein, die eine nahezu beliebige Einstellung der Form des Hohlspiegels 4 ermöglichen.

In einem nächsten Schritt 302 kann mindestens ein den eingestellten Zustand des Hohlspiegels bestimmender Parameter bestimmt werden. Bei dem Parameter bzw. Parameterwert kann es sich um einen Parameter handeln, der unmittelbar die Form und/oder die Position des Hohlspiegels 4 repräsentiert. Beispiele hierfür sind insbesondere geometrische Parameter. Es können alternativ oder zusätzlich Parameter bestimmt werden, die Form und/oder die Position des Hohlspiegels 4 beeinflussen, wie die Temperatur oder Feuchtigkeit des Hohlspiegels oder der Umgebung.

Beispielsweise kann der mindestens eine Parameter aus den Daten der Stelleinrichtung 18 und/oder der Steuereinrichtung 14 unmittelbar bestimmt, abgeleitet und/oder berechnet werden. Auch kann vorgesehen sein, dass die Erfassungseinrichtung 20 den mindestens einen Parameter vor dem Betreiben des Bauteils 4 oder unmittelbar zu Beginn des Betriebs erfasst.

Der mindestens eine bestimmte Parameter kann insbesondere als Sollparameter in einer Speichereinrichtung der Vergleichseinrichtung 22 gespeichert werden. Zusätzlich können vorzugsweise obere und untere Grenzwert des Sollparameters festgelegt werden, die insbesondere von der Anwendung und der gewünschten Genauigkeit, mit der das Bauteil 4 betrieben werden soll, abhängen können. Beispielsweise können Eingabevorrichtungen, wie eine Tastatur, und ein Display, vorgesehen sein.

Dann kann das Bauteil 4 bzw. das System 2 betrieben werden. Ferner kann ein Istwert des mindestens einen Parameters von der Erfassungseinrichtung 20 in einem Schritt 303 erfasst werden.

In einem nächsten Schritt 304 kann der erfasste Istwert in der Vergleichseinrichtung 22 mit dem Sollwert oder mit entsprechend vorgegebenen Grenzwerten verglichen werden. Das Vergleichsergebnis kann an die Steuereinrichtung 14 von der Vergleichseinrichtung 22 übertragen werden. Bevorzugt kann das Vergleichsergebnis nur bei einer detektierten Abweichung an die Steuereinrichtung 14 übertragen werden.

Solange das mindestens eine Bauteil 4 betrieben wird, können die Schritte 303 und 304 beispielsweise regelmäßig durchgeführt werden. Der mindestens eine Parameter kann insbesondere in vorgebbaren Zeitabständen erfasst werden. Auch ist eine nahezu kontinuierliche Erfassung oder eine unregelmäßige Erfassung, beispielsweise in Abhängigkeit eines externen Signals, möglich.

Bei einer detektierten Abweichung, beispielsweise bei Überschreiten oder Erreichen eines oberen Grenzwertes oder bei Unterschreiten oder Erreichen eines unteren Grenzwertes, ist die Steuereinrichtung 14 dazu eingerichtet, in dem nächsten Schritt 305 ein elektrisches Signal an die erste Elektrode 8 und die mindestens zweite Elektrode 10 anzulegen, derart, dass die Abweichung des Istwertes von dem Sollwert ausgeglichen wird. Beispielsweise kann die Steuereinrichtung 14 aus der detektierten Abweichung berechnen, welche Spannungsänderung an die zumindest zwei Elektroden 8, 10 der zumindest einen elektromechanischen Wandlereinrichtung zum Ausgleichen bzw. Kompensieren der Abweichung, also zum Wiederherstellen des Grundzustands, anzulegen ist. Mit anderen Worten ist es möglich, ungewünschte Zustandsänderung beispielsweise in Folge von einer Änderung der Temperatur und/oder der Feuchtigkeit der Umgebung, nahezu unmittelbar auszugleichen. Ein fehlerfreier Betrieb des mindestens einen Bauteils kann sichergestellt werden.

Auch ist es möglich, dass in einem Speicher der Steuereinrichtung 14 Änderungswerte des elektrischen Signals zusammen mit Abweichungswerten beispielsweise aufgrund einer vorherigen Testphase gespeichert wurden. Bestimmte Abweichungen können zusammen mit Spannungsänderungswerten abgespeichert sein. Bei dem Auftreten einer Abweichung kann die Steuereinrichtung 14 den Speicher nach einem entsprechenden Abweichungswert durchsuchen und das Spannungssignal entsprechend des Spannungsänderungswerts anpassen.

Es sei an dieser Stelle angemerkt, dass insbesondere ungewünschte Zustandsänderungen des mindestens einen Bauteils ausgeglichen werden können. Es versteht sich, dass während des Betriebs des Bauteils der Zustand gezielt geändert werden kann. Bei einer Änderung, beispielsweise auch einer kontinuierlichen Änderungen, können die gespeicherten Sollparameter entsprechend angepasst werden.

## Patentansprüche

1. Verfahren zum Betreiben eines Bauteils (4), wobei das Bauteil (4) mindestens eine elektromechanische Wandlereinrichtung umfassend mindestens eine zwischen einer ersten Elektrode (8) und mindestens einer zweiten Elektrode (10) angeordnete elektroaktive Schicht (12) aufweist, umfassend:
- Einstellen eines vorgebbaren Zustands des Bauteils (4) vor dem Betreiben des Bauteils (4), wobei mindestens ein erster Parameterwert eines den vorgebbaren Zustand bestimmenden ersten Parameters als erster Sollwert bestimmt wird,
- Erfassen eines Istwertes des ersten Parameters während des Betriebs des Bauteils (4),
- Vergleichen des erfassten Istwertes des ersten Parameters mit dem bestimmten Sollwert des ersten Parameters, und
- Anlegen eines elektrischen Signals an die erste Elektrode (8) und die mindestens zweite Elektrode (10) bei Detektion einer vorgebbaren Abweichung des Istwertes des ersten Parameters von dem Sollwert des ersten Parameters, derart, dass die Abweichung des Istwertes des ersten Parameters von dem Sollwert des ersten Parameters zumindest reduziert wird.

2. Verfahren nach Anspruch 1, **dadurch gekennzeichnet, dass** der Istwert des ersten Parameters während des Betriebs des Bauteils (4) in vorgebbaren Zeitabständen erfasst wird.

3. Verfahren nach Anspruch 1 oder 2, **dadurch gekennzeichnet, dass** die mindestens eine elektroaktive Schicht (12) eine dielektrische Elastomerschicht (12) ist.

4. Verfahren nach Anspruch 3, **dadurch gekennzeichnet, dass** die dielektrische Elastomerschicht (12) ein Material umfasst, das ausgewählt ist aus der Gruppe umfassend Polyurethan-Elastomere, Silikon-Elastomere und/oder Acrylat- Elastomere.

5. Verfahren nach einem der vorherigen Ansprüche, **dadurch gekennzeichnet, dass** eine vorgebbare Position und/oder vorgebbare Form des Bauteils (4) zum Betreiben des Bauteils (4) eingestellt wird.

6. Verfahren nach eine der vorherigen Ansprüche, **dadurch gekennzeichnet, dass** während des Betriebs des Bauteils (4) der vorgebbarer Zustand geändert wird, wobei mindestens der erste Parameterwert des den geänderten Zustand bestimmenden ersten Parameters als erster Sollwert bestimmt wird.

7. Verfahren nach einem der vorherigen Ansprüche, **dadurch gekennzeichnet, dass**
- mindestens ein weiterer Parameterwert eines den vorgebbaren Zustand bestimmenden weiteren Parameters als weiterer Sollwert bestimmt wird,
- ein Istwert des weiteren Parameters während des Betriebs des Bauteils (4) erfasst wird,
- der erfasste Istwert des weiteren Parameters mit dem bestimmten weiteren Sollwert verglichen wird, und
- ein elektrisches Signal an die erste Elektrode (8) und die mindestens zweite Elektrode (10) bei Detektion einer vorgebbaren Abweichung des weiteren Istwertes des weiteren Parameters von dem weiteren Sollwert des weiteren Parameters angelegt wird, derart, dass die Abweichung des weiteren Istwertes des weiteren Parameters von dem weiteren Sollwert des weiteren Parameters zumindest reduziert wird.

8. Verfahren nach einem der vorherigen Ansprüche, **dadurch gekennzeichnet, dass** mindestens ein Parameter ausgewählt ist aus der Gruppe geometrischer Parameter, Gewichtsparameter, Feuchtigkeitsparameter und/oder ein Temperaturparameter ist.

9. System (2, 2.1), umfassend:
- mindestens ein zu betreibendes Bauteil (4), wobei das Bauteil (4) mindestens eine elektromechanische Wandlereinrichtung umfassend mindestens eine zwischen einer ersten Elektrode (8) und mindestens einer zweiten Elektrode (10) angeordnete elektroaktive Schicht (12) aufweist,
- mindestens eine Stelleinrichtung (18) konfiguriert zum Einstellen eines vorgebbaren Zustands des Bauteils (4) zum Betreiben des Bauteils (4), wobei mindestens ein erster Parameterwert eines den vorgebbaren Zustand bestimmenden ersten Parameters als erster Sollwert bestimmt wird,
- mindestens eine Erfassungseinrichtung (20, 20.1, 20.2) konfiguriert zum Erfassen eines Istwertes des ersten Parameters während des Betriebs des Bauteils (4),
- mindestens eine Vergleichseinrichtung (22) konfiguriert zum Vergleichen des erfassten Istwertes des ersten Parameters mit dem bestimmten Sollwert des ersten Parameters, und
- mindestens eine Steuereinrichtung (14) konfiguriert zum Anlegen eines elektrischen Signals an die erste Elektrode (8) und die mindestens zweite Elektrode (10) bei Detektion einer vorgebbaren Abweichung des Istwertes des ersten Parameters von dem Sollwert des ersten Parameters, derart, dass die Abweichung des Istwertes des ersten Parameters von dem Sollwert des ersten Parameters zumindest reduziert wird.

10. System (2, 2.1) nach Anspruch 9, **dadurch gekennzeichnet, dass** das Bauteil (4) an mindestens einer Halteeinrichtung (6, 6.1) befestigt ist, wobei die Halteeinrichtung (6, 6.1) mindestens eine weitere elektromechanische Wandlereinrichtung umfassend mindestens eine zwischen einer ersten Elektrode und mindestens einer zweiten Elektrode angeordnete elektroaktive Schicht aufweist.

11. System (2, 2.1) nach Anspruch 9 oder 10, **dadurch gekennzeichnet, dass** die mindestens eine Steuereinrichtung (14) konfiguriert ist zum Anlegen eines elektrischen Signals an die erste Elektrode und die mindestens zweite Elektrode der weiteren elektromechanischen Wandlereinrichtung bei Detektion einer vorgebbaren Abweichung des Istwertes des ersten Parameters von dem Sollwert des ersten Parameters, derart, dass die Abweichung des Istwertes des ersten Parameters von dem Sollwert des ersten Parameters zumindest reduziert wird.

12. System (2, 2.1) einem der vorherigen Ansprüche 9 bis 11, **dadurch gekennzeichnet, dass** mindestens eine elektromechanische Wandlereinrichtung als gerollter elektromechanischer Aktuator oder als gestapelter elektromechanischer Aktuator ausgebildet ist.

13. System (2, 2.1) nach einem der vorherigen Ansprüche 9 bis 12, **dadurch gekennzeichnet, dass** das Bauteil (4) ein optisches Bauteil (4), insbesondere ein Hohlspiegel (4), ist.

14. Verwendung des Systems (2, 2.1) nach einem der vorherigen Ansprüche 9 bis 13 zum Kompensieren von mindestens einer Zustandsänderungen eines Bauteils (4) während des Betriebs des Bauteils (4).

15. Scheinwerfer umfassend ein System (2, 2.1) nach einem der vorherigen Ansprüche 9 bis 13.
